# EUROPEAN PATENT SPECIFICATION

(11) **EP 3 741 625 B1**
(45) Date of publication and mention of the grant of the patent: **24.11.2021**
(21) Application number: 20171416.9
(22) Date of filing: 24.04.2020
(51) Int. Cl.: B60R 13/02, B60R 11/02

(54) **ELECTRONIC COMPONENT ASSEMBLY, COMBINATION OF ELECTRONIC COMPONENT ASSEMBLY AND ADHEREND, AND METHOD FOR MOUNTING ELECTRONIC COMPONENT**
ELEKTRONISCHE KOMPONENTENANORDNUNG, KOMBINATION EINER ELEKTRONISCHEN KOMPONENTENANORDNUNG UND EINER KLEBEFLÄCHE SOWIE VERFAHREN ZUR MONTAGE EINER ELEKTRONISCHEN KOMPONENTE
ENSEMBLE COMPOSANT ÉLECTRONIQUE, COMBINAISON D'UN ENSEMBLE COMPOSANT ÉLECTRONIQUE ET PARTIE ADHÉRÉE, ET PROCÉDÉ DE MONTAGE DE COMPOSANT ÉLECTRONIQUE

(30) Priority: 20.05.2019 JP 2019094462; 26.08.2019 JP 2019153819
(43) Date of publication of application: 25.11.2020
(73) Proprietor: Hosiden Corporation, Yao-shi, Osaka 581-0071 (JP)
(72) Inventor: NODA, Shushin, Yao-shi, Osaka 581-0071 (JP); KUSUDA, Daisuke, Yao-shi, Osaka 581-0071 (JP); ONOYAMA, Kota, Yao-shi, Osaka 581-0071 (JP); TAKESHITA, Atsuro, Yao-shi, Osaka 581-0071 (JP)
(74) Representative: Gill Jennings & Every LLP

(56) References cited:
- DE-A1-102008 007 042
- DE-A1-102010 044 996
- DE-A1-102010 049 818
- DE-A1-102015 016 206
- DE-B3-102015 212 599
- US-A1- 2012 000 302

## Description

### TECHNICAL FIELD

The invention relates to electronic component assemblies, combinations of electronic component assemblies and adherends, and methods for mounting electronic components.

### BACKGROUND ART

Japanese Unexamined Patent Publication No. 2009-264564 describes a conventional combination of an electronic component assembly and an adherend. This combination includes a lining (headliner) of a ceiling part of an automobile, an electronic component serving as a microphone, an exterior case, and a mounting part. The headliner includes the adherend. The adherend has an upper face on one side in its thickness direction, a lower face opposite to the upper face, and a through-hole extending from the upper face to the lower face. The microphone is covered with the exterior case of metal. The exterior case includes a first side face with two first engaging holes, and an opposite, or second, side face with two second engaging holes. The microphone with the exterior case is disposed above the through-holes of the adherend. The mounting part includes a base, two first legs, and two second legs. The base of the mounting part abuts the lower face of the adherend so as to close the through-hole of the adherend. The first and second legs of the mounting part are inserted through the through-hole of the adherend from the lower face side of the adherend. The first and second legs have respective claws disposed above the upper face of the adherend. The claws of the first legs are hooked on the corresponding first engaging holes of the exterior case of the microphone, and the claws of the second legs are hooked on the corresponding second engaging holes of the exterior case of the microphone. Accordingly, the microphone with the exterior case is fixed on the upper face side of the adherend. DE-10200807042 discloses a combination of an electronic controller assembly and an adherent according to the preamble of claim 1 and a method for assembling an electronic component according to the preamble of claim 10.

### SUMMARY OF INVENTION

### Technical Problem

The lower face of the adherend of the lining of the ceiling part of the car is covered with a cushioning material, and the cushioning material is covered with a cloth. The base of the mounting part is disposed on the lower face of the adherend, so that the cushioning material and the cloth deform conforming to the base. As a result, the shape of the base appears on the cushioning material and the cloth.

Thus, the invention provides an electronic component assembly, a combination of the electronic component assembly and an apprehend, and a method for mounting an electronic component, in which an electronic component is assembled to an adherend with no part of the electronic component assembly disposed on the side of a particular face of an adherend.

### Solution to Problem

To solve the above problem, the present invention is provided as defined in the appended claims.

### BRIEF DESCRIPTION OF DRAWINGS

Fig. 1A is a front, top, right side perspective view of a combination of an electronic component assembly and an adherend according to a first embodiment of the invention.
Fig. 1B is a rear, top, left side perspective view of the combination.
Fig. 2A is a sectional view of the combination, taken along line 2A-2A in Fig. 1A.
Fig. 2B is a sectional view of the combination, taken along line 2B-2B in Fig. 2A.
Fig. 2C is a sectional view of the combination, taken along line 2C-2C in Fig. 2A.
Fig. 3 is a front, top, right side perspective view of an adherend, a cushioning material, and a cloth of the combination.
Fig. 4A is a front, top, left side perspective view of an electronic component assembly of the combination.
Fig. 4B is a front, bottom, right side perspective view of the electronic component assembly of the combination.
Fig. 5A is an exploded, front, top, left side perspective view of the electronic component assembly of the combination.
Fig. 5B is an exploded, rear, bottom, left side perspective view of the electronic component assembly of the combination.
Fig. 6A is a sectional view, corresponding to Fig. 2A, of a combination of an electronic component assembly and an adherend according to a second embodiment of the invention.
Fig. 6B is a sectional view of the combination, taken along line 6B-6B in Fig. 6A.
Fig. 6C is a sectional view of the combination, taken along line 6C-6C in Fig. 6A.
Fig. 6D is a sectional view of the combination, taken along line 6D-6D in Fig. 6A.
Fig. 7 is a front, top, right side perspective view of an adherend, a cushioning material, and a cloth of the combination.
Fig. 8 is a front, bottom, right side perspective view of the electronic component assembly of the combination.

In the brief description of the drawings above and the description of embodiments which follows, relative spatial terms such as "upper", "lower", "top", "bottom", "left", "right", "front", "rear", etc., are used for the convenience of the skilled reader and refer to the orientation of the electronic component assemblies, combinations of electronic component assemblies and adherends, and their constituent parts as depicted in the drawings. No limitation is intended by use of these terms, either in use of the invention, during its manufacture, shipment, custody, or sale, or during assembly of its constituent parts or when incorporated into or combined with other apparatus.

### DESCRIPTION OF EMBODIMENTS

Various embodiments of the invention will now be described. Elements of the embodiments and the design variations to be described can be combined with in any possible manner. Materials, shapes, dimensions, numbers, arrangements, etc. of the constituents of the combination of an electronic component assembly and an adherend, and those of the electronic component assembly, in the embodiments and the design variations will be discussed below as examples and can be modified as long as they achieve similar functions.

### First Embodiment

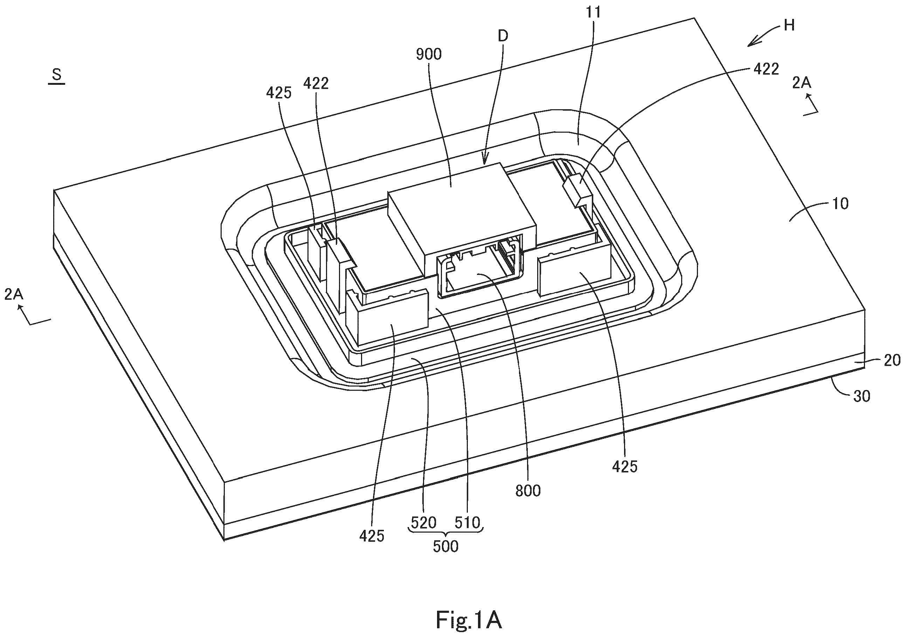

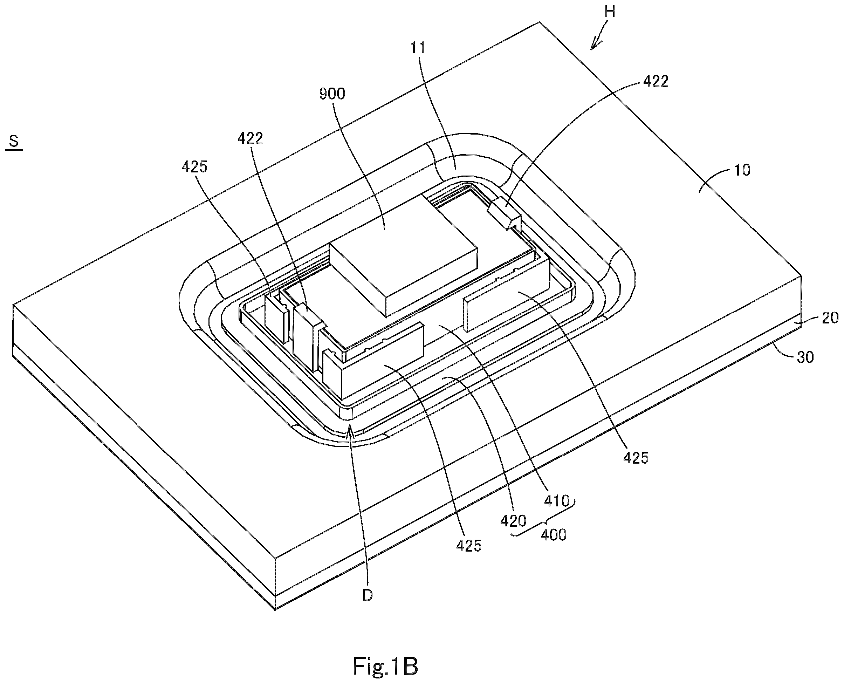

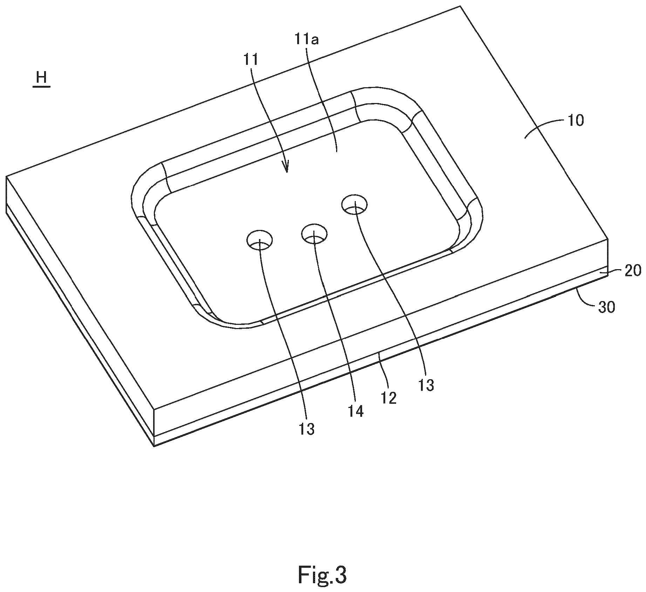

Hereinafter described is a combination S of an electronic component assembly D and an adherend 10 (this combination may be referred to simply as a combination S) according to various embodiments the invention, including a first embodiment, with reference to Figs. 1A to 5B. Figs. 1A to 5B. These figures illustrate the combination S of the first embodiment.

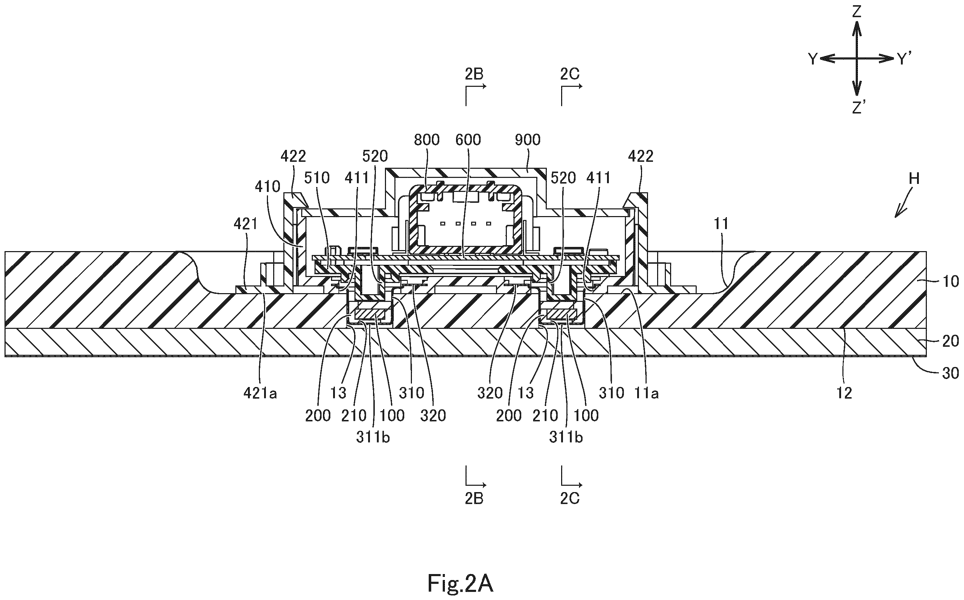

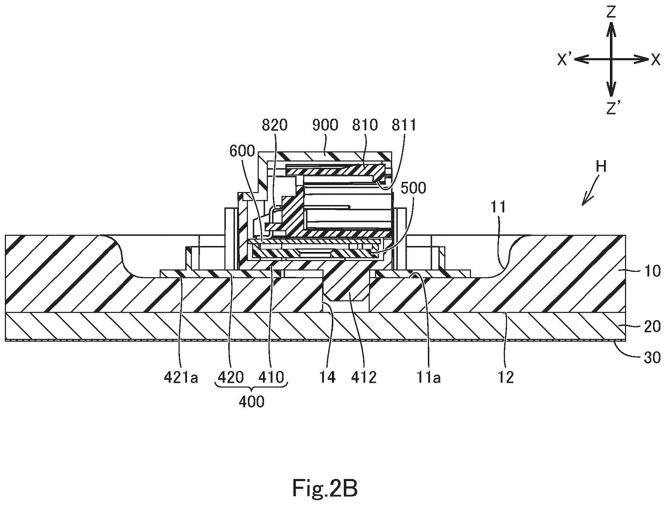

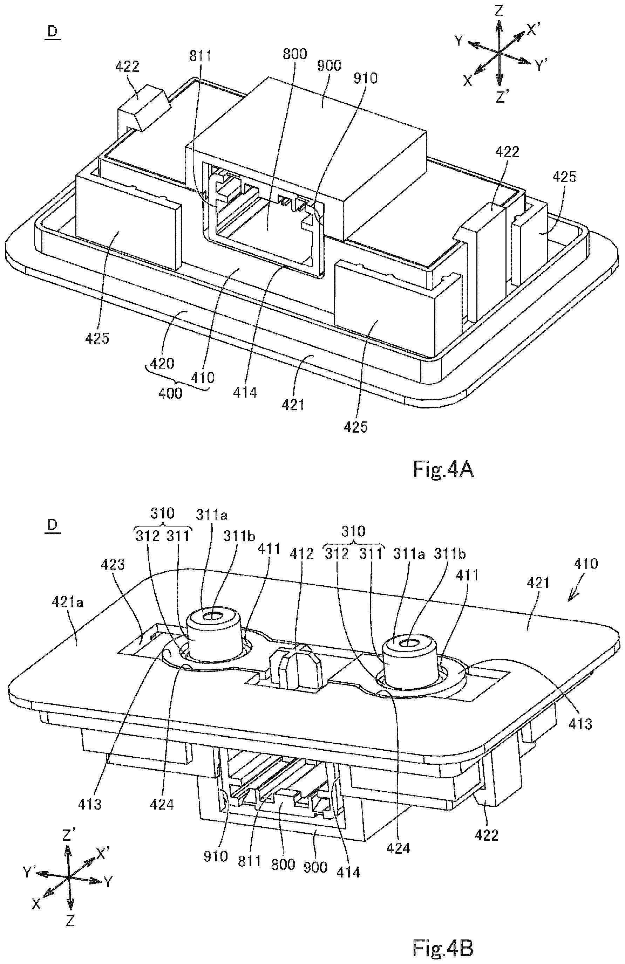

The combination S may include a lining H of a ceiling part of a vehicle, and an electronic component assembly D, which may be referred to hereinafter as the headliner H and the assembly D, respectively. In this case, the headliner H includes the adherend 10. The Z-Z' direction as shown in Figs. 2A to 2C, and 4A and 4B may correspond to a thickness direction of the adherend 10. The Z-Z' direction includes Z and Z' directions respectively corresponding to the first and second directions and being opposite to each other. The Y-Y' direction as shown in Figs. 2A, and 4A to 4B is substantially orthogonal to the Z-Z' direction. The X-X' direction as shown in in Figs. 2B to 2C and 4A to 4B is substantially orthogonal to the Z-Z' and Y-Y' directions.

The adherend 10 may be a molded plastic article. The adherend 10 includes a first main face on a Z-direction side and a second main face on a Z'-direction side. The first main face may be provided with a recess 11 opening in the Z direction. In this case, the bottom face of the recess 11 may serve as a first face 11a of the adherend 10. Where the recess 11 is not provided, the first main face itself may serve as the first face 1 1a of the adherend 10.

The second main face may serve as a second face 12 of the adherend 10. The second main face may also be provided with a recess (not illustrated) opening in the Z' direction. In this case, the bottom face of the recess may serve as the second face 12 of the adherend 10.

The adherend 10 further includes at least one housing hole 13. The or each housing hole 13 may be a through-hole extending from the first face 11a to the second face 12 and opening in the Z and Z' directions. Alternatively, the or each housing hole 13 may be a blind hole in the first face 11a, opening in the Z direction and closing on the Z'-direction side. In the embodiment shown in Figs. 1A to 3, the adherend 10 has two housing holes 13, which are through-holes spaced from each other along the Y-Y' direction.

The adherend 10 may further include at least one positioning hole 14. The or each positioning hole 14 may be a through-hole extending from the first face 11a to the second face 12 and opening in the Z and Z' directions. Alternatively, the or each positioning hole 14 may be a blind hole in the first face 11a, opening in the Z direction and closing on the Z'-direction side. In the embodiment shown in Figs. 1A to 3, there is provided one positioning hole 14, which is a through-hole located between the two housing holes 13.

The headliner H may further include a cushioning material 20. The cushioning material 20 has a face on the Z-direction side and a face on the Z'-direction side. The face on the Z-direction side of the cushioning material 20 is bonded to the second face 12 of the adherend 10. Where the at least one housing hole 13 and/or the at least one positioning hole 14 of the adherend 10 is a through-hole or through-holes, the through-hole or through-holes are closed from the Z'-direction side by the cushioning material 20. The cushioning material 20 may be omitted.

The headliner H may further include a cloth 30 made of fabric or the like material. The cloth 30 is bonded to the face on the Z'-direction side of the cushioning material 20. Where the cushioning material 20 is omitted, the cloth 30 may be bonded to the second face 12 of the adherend 10. Where the cushioning material 20 is omitted and the at least one housing hole 13 and/or the at least one positioning hole 14 of the adherend 10 is a through-hole or through-holes, the through-hole or through-holes are closed from the Z'-direction side by the cloth 30. The cloth 30 may also be omitted.

The assembly D includes at least one electronic component 100 (one or a plurality of electronic components 100). The number of the at least one electronic component 100 may be in accordance with the number of the at least one housing hole 13. The or each of the electronic components 100 may be an acoustic component, such as a microphone or a speaker. The microphone includes an input part, such as a sound hole, for receiving audio signals. The speaker includes an output part for outputting audio signals from a speaker.

The assembly D may further include at least one holder 200 (one or a plurality of holders 200). The number of the at least one holder 200 may be in accordance with the number of the at least one electronic component 100. The or each holder 200 is constituted by an elastic body of rubber or other material. The or each holder 200 has such a shape as to accommodate the or a respective electronic component 100. For example, the or each holder 200 may be a case for housing the or a respective electronic component 100 and have inner dimensions that are substantially equal to, or slightly smaller than, the outer dimensions of the or a respective electronic component 100. In this case, the or each electronic component 100 are fittingly received in the or a respective holder 200. The or each holder 200 may have at least one through-hole 210 at a portion on the Z'-direction side facing the input part or the output part of the or a respective electronic component 100. The at least one through-hole 210 may be omitted.

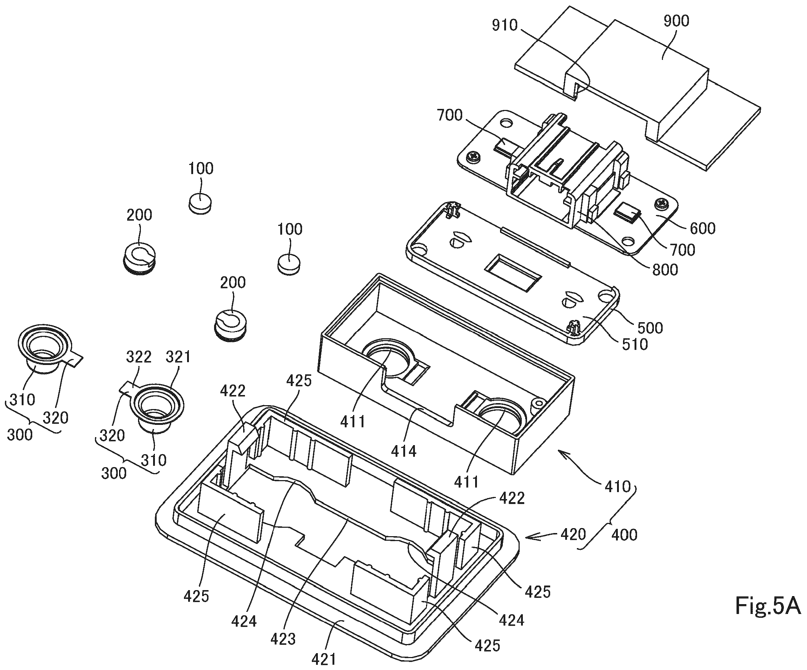

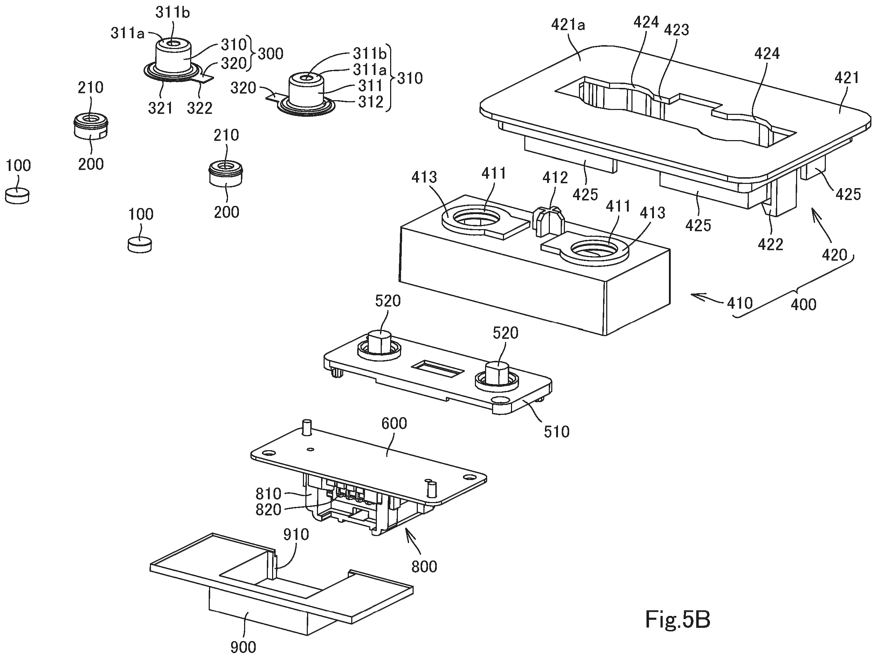

The assembly D further includes at least one housing 300 (one or a plurality of housings 300). The number of the at least one housing 300 may be in accordance with the number of the at least one electronic component 100. The or each housing 300 includes a housing body 310 and a fixed portion 320. For example, the housing body 310 may be of a generally tubular shape having a circular cross-section (see Figs. 5A and 5B) or a polygonal cross-section (not illustrated). The housing body 310 may open in the Z direction and include a bottom 311a on the Z'-direction side.

Where the at least one holder 200 is provided, the housing body 310 of the or each housing 300 may house the or a respective electronic component 100 and the or a respective holder 200 in a manner (1) or (2) below.
(1) In a cross section along the Y-Y' direction, the or each housing body 310 has inner dimensions that correspond to the outer dimensions of the or a respective holder 200. The or each holder 200 fits in, and is held inside, the or a respective housing body 310. In this case, the or each holder 200 may abut the bottom 311a of the or a respective housing body 310, and the or each electronic component 100 held by the or a respective holder 200 may be in indirect abutment, via the or a respective holder 200, with the bottom 311a of the or a respective housing body 310 from the Z-direction side. Alternatively, the or each holder 200 may be out of abutment with, and held in air inside, the or a respective housing body 310. In this case, the or each housing body 310 may be provided without the bottom 311a.
(2) In a cross section along the Y-Y' direction, the or each housing body 310 has inner dimensions that are larger than the outer dimensions of the or a respective holder 200. The or each housing body 310 houses the or a respective electronic component 100 and holder 200. In this case, as described above, the or each electronic component 100 held by the or a respective holder 200 is in indirect abutment, via the or a respective holder 200, with the bottom 311a of the or a respective housing body 310 from the Z-direction side.

Where the at least one holder 200 is omitted, the housing body 310 of the or each housing 300 may house the or a respective electronic component 100 as described in a manner (3) or (4) below.
(3) In a cross section along the Y-Y' direction, the or each housing body 310 has inner dimensions that correspond to the outer dimensions of the or a respective electronic component 100. The or each electronic component 100 fits in, and is held inside, the or a respective housing body 310. In this case, the or each electronic component 100 may be in direct abutment with the bottom 311a of the or a respective housing body 310 from the Z-direction side. Alternatively, the or each electronic component 100 may be out of abutment with, and held in air inside, the or a respective housing body 310. In this case, the or each housing body 310 may be provided without the bottom 311a.
(4) In a cross section along the Y-Y' direction, the or each housing body 310 has inner dimensions that are larger than the outer dimensions of the or a respective electronic component 100. The or each housing body 310 houses the or a respective electronic component 100. In this case, the or each electronic component 100 is in direct abutment with the bottom 311a of the or a respective housing body 310 from the Z-direction side.

The bottom 311a of the or each housing body 310 may be provided with at least one through-hole 311b. The at least one through-hole 311b extends through the bottom 311a in the Z-Z' direction. Where the at least one holder 200 is provided, the through-hole 311b of the or each housing 300 communicates with the through-hole or through-holes 210 of the holder 200, or alternatively each of the through-holes 311b of the or each housing 300 communicates with the through-hole or through-holes 210 of the or a respective holder 200. Where the at least one holder 200 is omitted, the at least one through-hole 311b of the or each housing body 310 faces the input or output part of the or a respective electronic component 100. The bottom 311a of the or each housing body 310 may be a circular or polygonal plate with no through-holes 311b.

The housing body 310 of the or each housing 300 includes a first portion 311 and a second portion 312. The or each first portion 311 may be of a generally tubular shape (having a circular or polygonal cross-section, for example), and may include the aforementioned bottom 311a on the Z'-direction side of the housing body 310. The or each first portion 311 is housed in the or a respective housing hole 13 of the adherend 10 without protruding from the housing hole 13 in the Z' direction. As such, the or each first portion 311 has a dimension in the Z' direction (corresponding to a dimension in the second direction) equal to, or smaller than, the dimension in the Z' direction of the or a respective housing hole 13. Also, in a cross section along the Y-Y' direction, the or each first portion 311 has outer dimensions that are equal to, or smaller than, the inner dimensions of the or a respective housing hole 13. The or each second portion 312 is generally of a tubular shape (having a circular or polygonal cross-section, for example) extending in the Z direction from the first portion 311 of the or a respective housing body 310. The or each second portion 312 protrudes in the Z direction from the or a respective housing hole 13 with the or a respective first portion 311 housed in the or a respective housing hole 13. The or each second portion 312 may be omitted. The or each bottom 311a may also be omitted as discussed above.

In the or each housing 300, the fixed portion 320 is a flange and/or a piece member extending from the second portion 312 or the first portion 311 of the housing body 310 to be located in the Z direction relative to the first portion 311 of the housing body 310. In the embodiment shown in Figs. 2A to 2C, and 5A to 5B, the fixed portion 320 of each housing 300 includes a flange 321 of an annular shape, which extends outwardly from the rim on the Z-direction side of the second portion 312 of the housing body 310, and a piece member 322, which extends from the flange 321.

The or each housing 300 may be formed of a drawn thin plate of a metal (e.g., stainless steel). The thin plate may preferably, but not limited to, have a wall thickness of 0.5 mm or less. Alternatively, the or each housing 300 may be formed of a thin metal plate or a plastic member formed by casting or using a 3D printer.

The assembly D further includes a fixing part 400. The fixing part 400 is configured to allow the fixed portion 320 of the or each housing 300 to be fixed to the fixing part 400. The fixing part 400 is fixed (bonded or welded) to the first face 11a of the adherend 10. The fixing part 400 is disposed on the first face 11a of the adherend 10. Where the adherend 10 includes the recess 11, the fixing part 400 may be housed at least partly in the recess 11. The fixing part 400 may include a first fixing part 410 and a second fixing part 420 as described below.

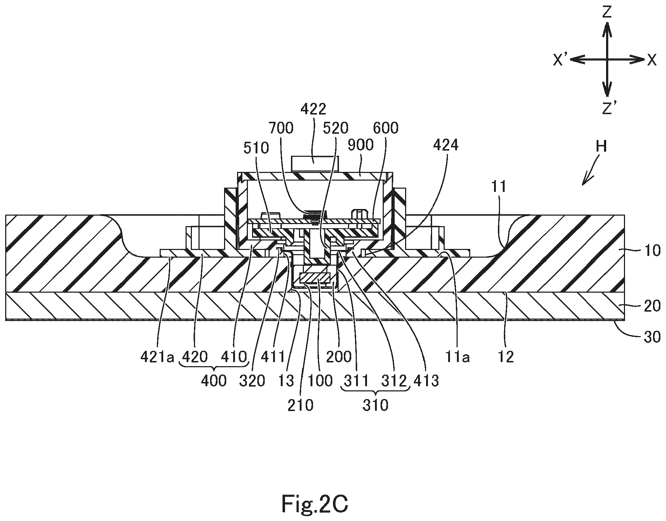

The first fixing portion 410 is configured to allow the fixed portion 320 of the or each housing 300 to be fixed to the first fixing portion 410. For example, the first fixing part 410 may be a molded plastic article, or part thereof, in which the fixed portion 320 of the or each housing 300 is insert-molded, or alternatively be a member of plastic or other material having a groove or hole to receive the fixed portion 320 of the or each housing 300. The first fixing part 410 may include at least one hole 411 (see Figs. 2A, 2C, and 5A to 5B). In this case, the number and position of the at least one hole 411 of the first fixing portion 410 is in accordance with those of the at least one housing 300. The or each hole 411 leaves open, in the Z direction, the opening on the Z-direction side of the housing body 310 of the or a respective housing 300.

In the embodiment of Figs. 1A to 2C, and 4A to 5B, the first fixing part 410 is a box opening in the Z direction, having a bottom and a generally tubular wall extending from the bottom in the Z direction. The bottom is provided with two holes 411 spaced from each other along the Y-Y' direction to leave open the corresponding openings on the Z-direction side of the housing bodies 310 of the two housings 300. In portions of the bottom that surround the respective holes 411, the respective fixed portions 320 of the two housing 300 are insert-molded in spaced relation from each other in the Y-Y' direction.

Where at least one hole 411 is omitted, the first fixing part 410 may be a plate or block, to which the fixed portion 320 of the housing body 310 of the or each housing 300 is fixed. Such first fixing part 410 may close or may not close the opening on the Z-direction side of the or each housing body 310.

The first fixing part 410 may further include at least one first protrusion 412 extends in the Z' direction. The at least one first protrusion 412 may be provided as one or more first protrusions 412 in accordance with the number of the at least one positioning hole 14 of the adherend 10. The or each first protrusion 412 is fittingly received in the or a respective positioning hole 14. Thus, the or each first protrusion 412 has dimensions in the Y-Y' and X-X' directions that are substantially equal to, slightly larger than, or slightly smaller than, the dimensions in the Y-Y' and X-X' directions of the corresponding positioning hole 14. In place of the at least one first protrusion 412 and the at least one positioning hole 14, at least one first protrusion may be provided on the adherend 10, and the first fixing part 410 may include at least one positioning hole corresponding in number and position to the at least one first protrusion. The at least one first protrusion and the at least one positioning hole may be omitted.

The first fixing part 410 may fixed to the second fixing part 420 by mechanical engaging, bonding, welding, and/or screwing. For convenience of explanation, one of the second fixing part 420 and the first fixing part 410 is may be referred to hereinafter as one of the fixing parts or one fixing part, and the other as the other fixing part.

Where the first fixing part 410 is attached to the second fixing part 420 by mechanical engagement, one of the fixing parts is provided with at least one engaging claw or engaging protrusion, and the other fixing part includes at least one wall or engaging hole. In this case, the first fixing part 410 is attached to the second fixing part 420 by hooking the or each engaging claw 422 of the one fixing part on an edge of the or a respective wall of the other fixing part, or on an edge of the or a respective engaging hole; or by fitting the or each engaging protrusion of the one fixing part into the or a respective engaging hole of the other fixing part. In the embodiment shown in Figs. 1A to 2C, and 4A to 5B, the second fixing part 420 includes a base 421 and two arms extending in the Z direction from the base 421. The arms are spaced from each other along the Y-Y' direction. The arms on the Y- and Y'-direction sides are provided at their respective leading ends with respective engaging claws 422. The engaging claws 422 are hooked, from the Z-direction side, on edges on the Z-direction side of the portions on the Y- and Y'-direction sides of the tubular wall of the first fixing part 410.

The second fixing part 420 is fixed to the first face 11a of the adherend 10 by bonding or welding. The second fixing part 420 includes a base 421 having a mounting face 421a to be mounted on the first face 11a of the adherend 10. The mounting face 421a is the face on the Z'-direction side of the base 421 of the second fixing part 420. The first fixing part 410 is disposed on (the Z-direction side of) the base 421 of the second fixing part 420. The base 421 of the second fixing part 420 includes at least one opening 423 or cutout for allowing the first portion 311 of the housing body 310 of the or each housing 300 to protrude in the Z' direction relative to the mounting face 421a of the fixing part 400. In other words, the first portion 311 of the housing body 310 of the or each housing 300 extends through the or a respective opening 423 or cutout to be disposed on the Z'-direction side relative to the mounting face 421a of the fixing part 400. Where a single opening 423 or a single cutout is provided, the opening 423 or cutout may be configured to receive therethrough the housing body 310 of the or each housing 300 (see Figs. 1A to 2C and 4A to 5B). Alternatively, where a plurality of openings 423 or cutouts is provided, the openings 423 or cutouts may be arranged in the second fixing part 420 at positions corresponding to the respective housing bodies 310 of a plurality of housings 300.

Where the first fixing part 410 includes the at least one first protrusion 412, the at least one first protrusion 412 may be inserted through the at least one opening 423 or cutout and protrude in the Z' direction relative to the mounting face 421a.

The one fixing part may further include at least one second protrusion 413, and the other fixing part may further include at least one positioning hole 424. The at least one second protrusion 413 may extend from the one fixing part toward the other fixing part. The at least one positioning hole 424 of the other fixing part correspond in number and position to the at least one second protrusion 413. The or each second protrusion 413 is fittingly received in the or a respective positioning hole 424, so that the first fixing part 410 is fixed in position to the second fixing part 420. Accordingly, the or each positioning hole 424 has a cross-sectional dimension in the Y-Y' direction that is equal to, or slightly larger or slightly smaller than, the cross-sectional dimension in the Y-Y' direction of the or a respective second protrusion 413. In the embodiment of Figs. 2A, 2C, and 5A to 5B, the first fixing part 410 includes two second protrusions 413, which are ringshaped protrusions surrounding the respective two holes 411, while the single opening 423 in the second fixing part 420 includes two positioning holes 424 corresponding in shape and position to the second protrusions 413. The at least one second protrusion 413 and the at least one positioning hole 424 may be omitted.

The second fixing part 420 may further include at least one positioning portion 425. The at least one positioning portion 425 may extend in the Z direction from the base 421 of the second fixing part 420 and surround the first fixing part 410. The at least one positioning portion 425 may abut the first fixing part 410. In the embodiment of Figs. 1A to 2C and 4B, there are four positioning portions 425 being generally L-shaped walls, as viewed from the Z-direction side, in abutment with respective corners of the walls of the first fixing part 410. The at least one positioning portion 425 may be omitted.

The assembly D further includes a support 500 and, alternatively, a circuit board 600. The support 500 includes a support body 510. The support body 510 is fixed to (the Z-direction side of) the first fixing part 410 in a similar manner to the fixing between the first and second fixing parts 410 and 420. In the embodiment of Figs. 2A to 2C, and 4A and 4B, the support body 510 is fixed to the bottom (the face on the Z-direction side) of the first fixing part 410, by engagement described above and screwing, and located on the Z-direction side relative to the bottom. The circuit board 600 is fixed to (the Z-direction side of) the support body 510 of the support 500 in a similar manner to the fixing between the first and second fixing parts 410 and 420. Where the support 500 is omitted, the circuit board 600 is fixed to the first fixing part 410 in a similar manner to the fixing between the first and second fixing parts 410 and 420. The one or more electronic components 100 are electrically connected to the circuit board 600 via a connecting means (not shown), such as a cable, cables, or lead wires. Where the circuit board 600 is omitted, the at least one electronic component 100 may be connected via the connection means to the outside.

The support 500 further includes at least one leg 520. The or each leg 520 is a protrusion extending from the support body 510 in the Z' direction. The at least one leg 520 may comprise one or more legs 520 corresponding in number to the at least one housing 300. In this case, the first fixing part 410 may include the at least one hole 411 corresponding in number to the at least one housing 300, and the at least one leg 520 may be arranged correspondingly in position to the at least one hole 411 and the at least one housing 300. Where the at least one holder 200 is provided, the or each leg 520 extends through the or a respective hole 411 to be received in the housing body 310 of the or a respective housing 300 from the Z-direction side, and to be brought into abutment with the or a respective holder 200 in the or a respective housing body 310. In other words, the or each leg 520 is in indirect abutment with the or a respective electronic component 100, via the or a respective holder 200, inside the or a respective housing body 310. Where the at least one holder 200 is omitted, the or each leg 520 extends through the or a respective hole 411 to be received in the housing body 310 of the or a respective housing 300 from the Z-direction side, and to be brought into direct abutment with the or a respective electronic component 100 inside the or a respective housing body 310. In an exemplary embodiment not being part of the present invention, the at least one leg 520 of the support 500 may be omitted in cases where the or each housing body 310 holds therein the or a respective holder 200 or the or a respective electronic component 100, or where the opening of the or each housing body 310 is 10 closed.

Where the circuit board 600 is provided, the assembly D may further include at least one circuit part 700 and/or a connector 800 mounted on the circuit board 600. Particularly, there may be provided a single circuit part 700 electrically connected to one or more electronic components 100 via the circuit board 600. Alternatively, there may be provided a plurality of circuit parts 700, which may be electrically connected to the corresponding electronic components 100 via the circuit board 600. If provided, the connector 800 includes a body 810 and a plurality of terminals 820. The body 810 is made of an insulating resin and has a connection hole 811. Each terminal 820 includes a contact portion disposed in the connection hole 811, a connection portion protruding out of the body 810 to be soldered to the circuit board 600. The connector 800 is electrically connected to the at least one circuit part 700 and/or to the at least one electronic component 100 via the circuit board 600. The at least one circuit part 700 and/or the connector 800 may be omitted.

Where the first fixing part 410 is a box opening in the Z direction, the assembly D may further include a cover 900. The cover 900 is attached to the tubular wall of the first fixing part 410 from the Z-direction side and closes the opening of the first fixing part 410 from the Z-direction side. Where the connector 800 is provided, the cover 900 is provided with a housing recess 910 opening in the Z' and X directions. The housing recess 910 houses a portion on the Z-direction side of the body 810 of the connector 800 and leave the connection hole 811 of the connector 800 open in the X direction. In the embodiment of Figs. 1A to 2C, and 4A and 4B, the engaging claws 422 of the respective arms on the Y- and Y'-direction sides of the second fixing part 420 are hooked, from the Z-direction side, not only on the edges on the Z-direction side of the respective portions on the Y- and Y'-direction sides of the tubular wall of the first fixing part 410, but also on the end portions on the Y- and Y'-direction sides of the cover 900. This arrangement maintains secure attachment of the cover 900 to the tubular wall of the first fixing part 410. The portion on the X-direction side of the tubular wall of the first fixing part 410 is provided with a cutout 414, which leaves the connection hole 811 of the connector 800 open in the X direction. The cover 900 may be omitted.

The following describes first and second methods for mounting the at least one electronic component 100 to the adherend 10. For convenience description, the first method will be described for the case where there are provided a single electronic component 100, a single holder 200, a single housing 300, a single opening 423 or cutout of the fixing part 400, and a single leg 520 of the support 500. However, it is also possible to assemble the assembly D in a similar manner by the first method also in the case where there are provided a plurality of electronic components 100, a plurality of holders 200, a plurality of housings 300, a plurality of openings 423 or cutouts of the fixing part 400, and a plurality of legs 520 of the support 500. Also, the second method will be described for the case where there are provided a single electronic component 100, a single holder 200, a single housing 300, and a single opening 423 or cutout of the fixing part 400. However, it is also possible to assemble the assembly D in a similar manner by the second method also in the case where there are provided a plurality of electronic components 100, a plurality of holders 200, a plurality of housings 300, and a plurality of openings 423 or cutouts of the fixing part 400. The second method deals with the assembly D with the support 500 omitted.

The first and second methods each include a method for assembling the assembly D and a method for mounting the assembly D to the adherend 10. As the first and second methods are similar to each other regarding the mounting of the assembly D to the adherend 10, the second method will not be described in this regard.

First, the following description is directed to the method for assembling the assembly D of the first method. The electronic component 100 and the holder 200 holding the electronic component 100 are prepared. The first fixing part 410 of the fixing part 400 and the housing 300 fixed to the first fixing part 410 are also prepared. The electronic component 100 and the holder 200 are housed in the housing body 310 of the housing 300. The holder 200 is then brought into abutment with the bottom 311a of the housing body 310. The support 500 is also prepared. The support body 510 of the support 500 is fixed to the first fixing part 410 in a manner described above. The leg 520 of the support 500 is then inserted into the housing body 310 and brought into abutment with the holder 200 inside the housing body 310. As a result, the holder 200 and the electronic component 100 are sandwiched between the bottom 311a of the housing body 310 and the leg 520. The electronic component 100 and the holder 200 are thus held inside the housing 300 fixed to the first fixing part 410.

Where the holder 200 is omitted, the above steps in the previous paragraph may be modified as follows. The electronic component 100 is housed in the housing body 310 of the housing 300, and that the electronic component 100 is brought into abutment with the bottom 311a of the housing body 310. The leg 520 of the support 500 is inserted into the housing body 310 and brought into abutment with the electronic component 100 inside the housing body 310. As a result, the electronic component 100 is sandwiched between the bottom 311a of the housing body 310 and the leg 520. The electronic component 100 is thus held inside the housing 300 fixed to first fixing part 410.

Before or after the electronic component 100 and the holder 200, or the electronic component 100, is held in the housing 300, the second fixing part 420 of the fixing part 400 is prepared. The housing body 310 of the housing 300 fixed to the first fixing part 410 is inserted through the opening 423 or cutout of the second fixing part 420, and the first portion 311 of the housing body 310 is made to protrude in the Z' direction, relative to the mounting face 421a of the second fixing part 420. The first fixing part 410 is then fixed to the second fixing part 420 in a manner as described above.

Where the first fixing part 410 includes the at least one first protrusion 412, when the first fixing part 410 is fixed to the second fixing part 420, the or each first protrusion 412 is inserted through the or a respective opening 423 cutout and protrudes in the Z' direction. Where one of the fixing parts, namely the first fixing part 410 or the second fixing part 420, includes the at least one second protrusion 413 and where the other fixing part further includes the at least one positioning hole 424, when the first fixing part 410 is fixed to the second fixing part 420, the or each second protrusion 413 fits into the or a respective positioning hole 424.

Where the assembly D includes the circuit board 600, the circuit board 600 may be prepared, before the support body 510 is fixed to the first fixing part 410, and then fixed to the support body 510 of the support 500 in a manner as described above. The circuit board 600 may be electrically connected to the at least one electronic component 100 via the above-described connection means before or after the circuit board 600 is fixed to the support body 510. The circuit board 600 to be prepared may or may not be provided thereon with the least one circuit part 700 and/or the connector 800. Where the circuit board 600 is omitted, the steps in this paragraph are omitted.

Where the first fixing part 410 is a box opening in the Z direction and the assembly D includes the cover 900, before the first fixing part 410 is fixed to the second fixing part 420, the cover 900 is attached to the tubular wall of the first fixing part 410 and closes the opening of the first fixing part 410. Where the connector 800 is mounted on the circuit board 600, after the support body 510 is fixed to the first fixing part 410 and the circuit board 600 is fixed to the support body 510, the cover 900 is attached to the tubular wall of the first fixing part 410 as described above and a part on the Z-direction side of the connector 800 is housed in the housing recess 910 of the cover 900. When the first fixing part 410 is fixed to the second fixing part 420, the engaging claws 422 on the Y and Y'-direction sides of the second fixing part 420 are hooked, from the Z-direction side, not only on the edges on the Z-direction side of the portions on the Y- and Y'-direction sides of the tubular wall of the first fixing part 410, and also on the corresponding end portions on the Y- and Y'-direction sides of the cover 900. Where the cover 900 is omitted, the steps in this paragraph are omitted. Where the connector 800 is not mounted on the circuit board 600, the step of housing the part on the Z-direction side of the connector 800 in the housing recess 910 of the cover 900 is omitted.

The assembly D is thus assembled in one of the manners described above.

The following description is directed to the method for mounting the assembly D to the adherend 10 of the first method. If provided, the cushioning material 20 and/or the cloth 30 may be bonded to the adherend 10 either before or after mounting the assembly D to the adherend 10.

The adherend 10 and the assembly D assembled are prepared. The mounting face 421a of the second fixing part 420 of the assembly D is placed on the first face 11a of the adherend 10. At this time, the first portion 311 of the housing body 310 of the assembly D is inserted into the housing hole 13 of the adherend 10. Where the first fixing part 410 of the assembly D includes the at least one first protrusion 412 and where the adherend 10 includes the at least one positioning hole 14, when the mounting face 421a of the second fixing part 420 is placed on the first face 11a of the adherend 10, the or each first projection 412 fits into the or a respective positioning hole 14, so that the assembly D is positioned relative to the adherend 10.

The second fixing part 420 of the assembly D placed on the first face 11a of the adherend 10 is fixed to the first face 11a by bonding or welding. The assembly D is thus attached to the adherend 10.

The following description is directed to the method for assembling the assembly D of the second method. This method is similar to, but different in respects below from, the method for assembling the assembly D of the first method, and therefore will be described focusing on the differences.

When the electronic component 100 and the holder 200 are housed inside the housing body 310 of the housing 300, the holder 200 is fitted in, and held by, the housing body 310. In this way, the electronic component 100 and the holder 200 are held inside the housing 300 fixed to the first fixing part 410.

Where the holder 200 is omitted, the electronic component 100 is housed in the housing body 310 of the housing 300 when the electronic component 100 is fitted in, and held by, the housing body 310. In this way, the electronic component 100 is held inside the housing 300 fixed to the first fixing part 410.

Where the assembly D includes the circuit board 600, the circuit board 600 may be fixed to the first fixing part 410 in a manner described above after the electronic component 100 and the holder 200, or alternatively the electronic component 100, is held inside the housing 300. The circuit board 600 may be electrically connected to the electronic component 100 via a connection means described above, either before or after the circuit board 600 is fixed to the first fixing part 410. The circuit board 600 may be prepared with or without the at least one circuit part 700 and/or the connector 800 mounted thereon. Where the circuit board 600 is omitted, the steps in this paragraph should be omitted.

The first and second methods may be such that, as described above, the assembly D is attached to the adherend 10 after the assembly D is assembled, but the first and/or second methods may be modified in the order of the steps as follows. The second fixing part 420 may be fixed to the first face 11a of the adherend 10 before the electronic component 100 and the holder 200, or alternatively the electronic component 100, is held inside the housing 300 fixed to the first fixing part 410. After that, the first fixing part 410 with the housing 300 may be fixed to the second fixing part 420, and then the electronic component 100 and the holder 200, or alternatively the electronic component 100, may be held inside the housing 300 fixed to the first fixing part 410.

The combination S, the assembly D, and the first and second methods described above provide at least the following technical features and effects.

(a) No part of the assembly D is disposed on the second face 12 side of the adherend 10 (no part of the assembly D is located on the Z'-direction side relative to the second face 12 of the adherend 10). This is because the fixing part 400 of the assembly D is only bonded or welded to the first face 11a of the adherend 10, and because the first portion 311 of the housing body 310 of the or each housing 300 of the assembly D is housed in the correspondence housing hole 13 in the adherend 10 without protruding in the Z' direction from the second face 12 of the adherend 10.

In particular, where the at least one housing 300 is formed of a thin metal plate, it is possible to reduce the thickness of the housing 300 while ensuring a predetermined strength of the housing 300. This makes it easy to reduce the dimension in the Z-Z' direction of the first portion 311 of the housing body 310 of the or each housing 300. Therefore, the first portion 311 of the or each housing 300 can be housed easily in the or a respective housing hole 13 of the adherend 10 without protruding in the Z' direction from the second face 12 of the adherend 10. Where the or each housing hole 13 of the adherend 10 is a blind hole opening in the Z direction, the first portion 311 of the or each housing body 310 in the corresponding housing hole 13 will not be seen through the cushioning material 20 and/or the cloth 30 by a user from the Z' direction.

(b) Where sandwiched between the bottom 311a of the or a respective housing 300 and the corresponding leg 520 of the support unit 500, the or each electronic component 100 and the or each holder 200, or alternatively the or each electronic component 100, can be easily fixed, simply by such sandwiching, in position inside the or a respective housing 300. In addition, the or each electronic component 100 and the or each holder 200, or alternatively the or each electronic component 100, is only sandwiched in the above manner. This sandwiching condition can be released simply by detaching the support body 510 of the support 500 from the first fixing part 410 to allow easy replacement of the at least one electronic component 100.

(c) The bottom 311a of the or each housing 300 is located on the Z'-direction side relative to the audio signal input part or the audio signal output part of the or a respective electronic component 100. If the bottom 311a of the or each housing 300 is of a large thickness, the thickness may impair acoustic characteristics of the corresponding electronic component 10. However, where the or each housing 300 is formed of a thin metal plate to include the bottom 311a of a small thickness, the thickness is unlikely to impair the acoustic characteristics of the corresponding electronic component 100. For example, where the or each electronic component 100 is a microphone, a large thickness of the bottom 311a would cause reduction of sound pressure in a high frequency range of sounds to be picked up by the microphone, but the small thickness of the bottom 311a alleviates reduction of sound pressure in a high frequency range of sounds to be picked up by the microphone.

(d) Where the or each electronic component 100 is held by the or a respective holder 200 being an elastic body, the or each holder 200 absorbs and thereby reduces vibrations subjected to the or a respective electronic component 100.

(e) When the first fixing part 410 of the fixing part 400 includes a plurality of first protrusions 412 and the adherend 10 includes a plurality of positioning holes 14, position and orientation of the assembly D relative to the adherend 10 can be easily determined by inserting the first protrusions 412 into the corresponding positioning holes 14.

### Second Embodiment

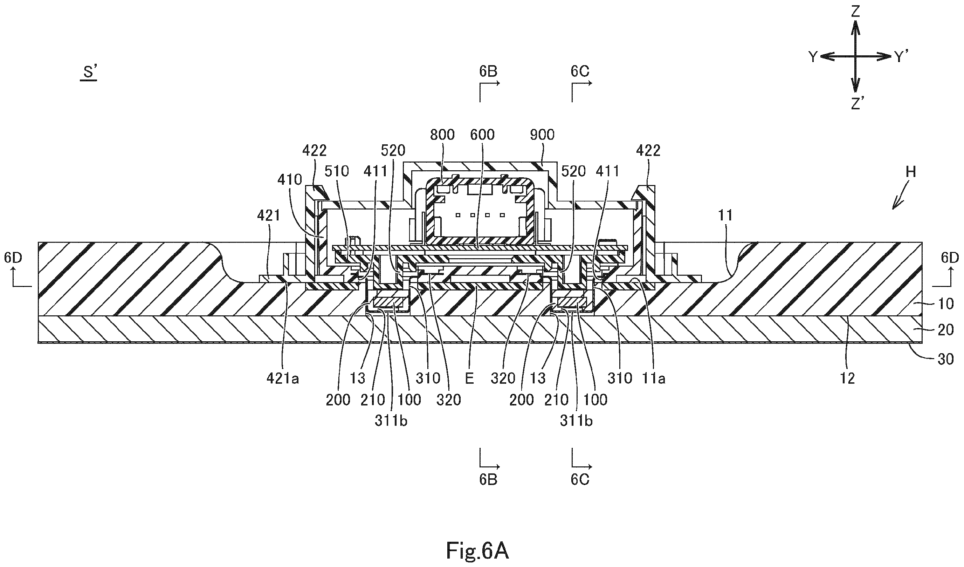

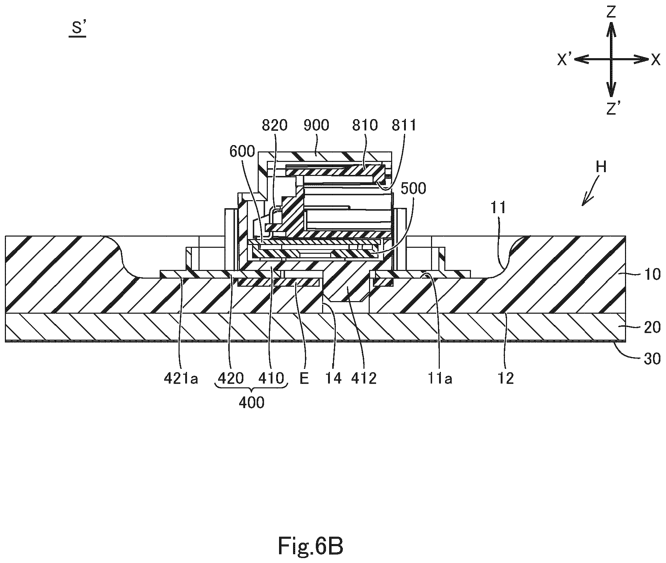

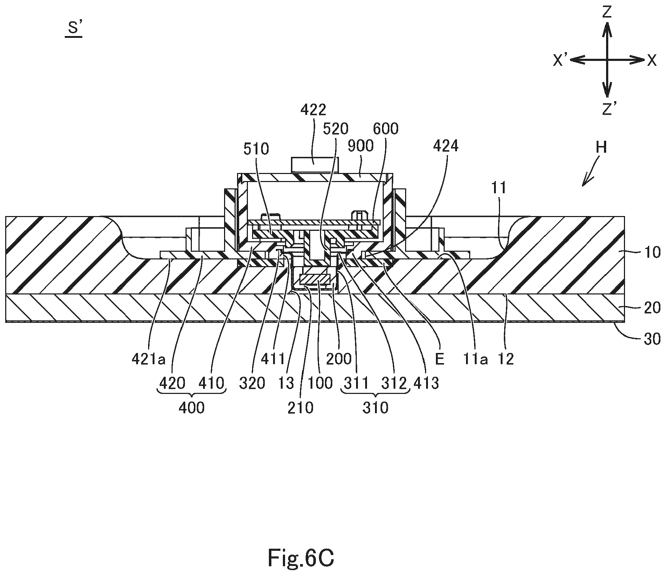

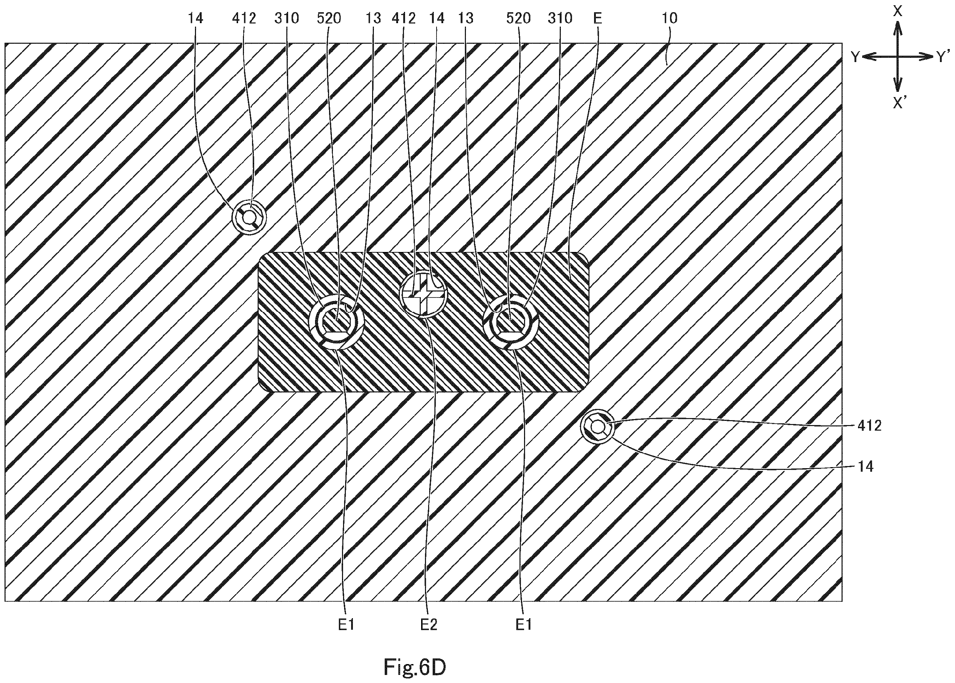

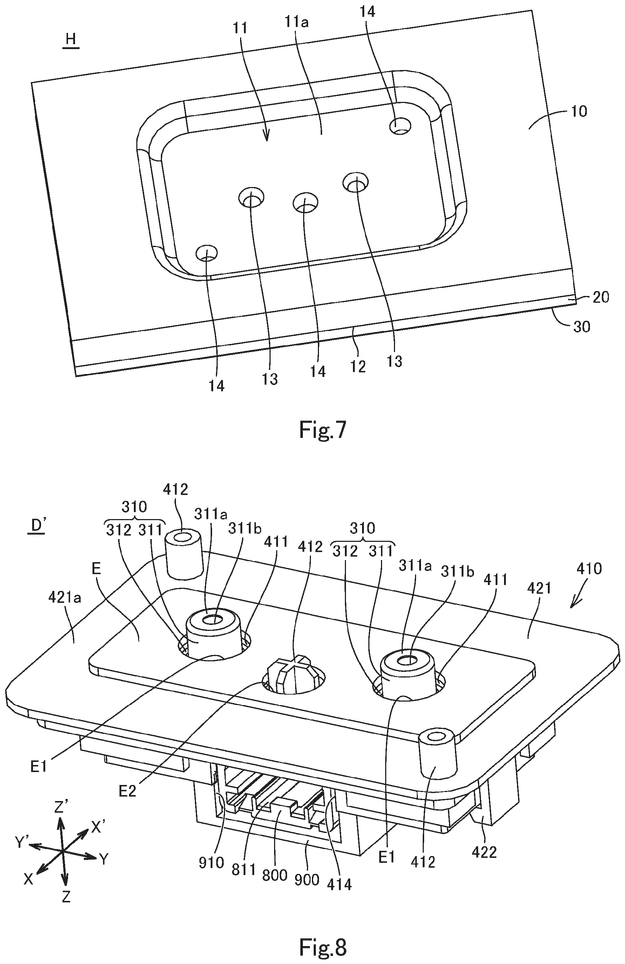

Hereinafter described is a combination S' of an electronic component assembly D' and an adherend 10 (this combination may be referred to simply as a combination S') according to a plurality of embodiments of the invention, including a second embodiment, with reference to Figs. 6A to 8. These figures illustrate the combination S' of the second embodiment. The combination S' may include a lining H of a ceiling of a vehicle, and an electronic component assembly D', which may be referred to hereinafter as the headliner H and the assembly D', respectively. The Z-Z' direction shown in Figs. 6A to 6C and 8, the X-X' direction shown in Figs. 6B to 6D and 8, and the Y-Y' direction shown in Figs. 6A, 6D, and 8 may be defined in a similar manner to the Z-Z', X-X', Y-Y' directions, respectively, of the first embodiment defined above.

The assembly D' differs from the assembly D of the combination S only in that the assembly D' further includes a seal member E but the assembly D does not. The assembly D' of the combination S' will be described focusing on the above difference from the assembly D of the combination S and omitting overlapping descriptions. The headliner H of the combination S' is similar in structure to the headliner H of the combination S.

The seal member E is a thin plate, which may be constituted by rubber foam made of ethylene propylene diene monomer rubber (EPDM rubber) or the like (e.g., Ept-Sealer (registered trademark) available from Nitto Denko Corporation), a double-sided tape, chloroprene rubber (e.g., neoprene sponge), a high-performance urethane foam made of a microcell polymer sheet (e.g., PORON (registered trademark) available from Rogers Inoac Corporation) or the like, for example. The seal member E may, but is not required to, have a thickness in a range from 0.4 to 0.8 mm, for example. For convenience of illustration, Figs. 6A to 6C, and 8 show the seal member E with an exaggerated thickness.

The seal member E is bonded or otherwise fixed to the face on the Z'-direction side of the fixing part 400. The seal member E is held and compressed between the face on the Z'-direction side of the fixing part 400 and the first face 11a of the adherend 10 of the headliner H.

Where the fixing part 400 includes the first fixing part 410 and the second fixing part 420, the seal member E is bonded or otherwise fixed to at least one of the face on the Z'-direction side of the first fixing part 410 and the mounting face 421a of the second fixing part 420. For example, where the first fixing part 410 includes the at least one second protrusion 413 surrounding the at least one hole 411, the seal member E may be fixed to a portion or portions of the first fixing part 410 that surrounds the at least one second protrusion 413. Alternatively, where the second fixing part 420 includes the at least one positioning hole 424 corresponding in shape and position to the at least one second protrusion 413, the seal member E may be fixed to a portion or portions of the second fixing part 420 that surrounds the at least one positioning hole 424 so as to cover the at least one positioning hole 424. Alternatively, where the first fixing part 410 includes the at least one second protrusion 413 surrounding the at least one hole 411, and where the second fixing part 420 includes the at least one positioning hole 424 corresponding in shape and position to the at least one second protrusion 413, the seal member E may be fixed to a portion or portions of the first fixing part 410 that surrounds the at least one second protrusion 413, and also to a portion or portions of the second fixing part 420 that surrounds the at least one positioning hole 424, so as to cover the at least one positioning hole 424 (see Figs. 6A to 6D, and 8).

The seal member E includes at least one through-hole E1. The at least one through-hole E1 in the seal member E corresponds in number and position to the at least one housing 300 and extends through the seal member E in the Z-Z' direction. The or each through-hole E1 is shaped so as to have a cross-sectional dimension in the Y-Y' direction that is substantially the same as, or slightly larger than, the cross-sectional outer dimension in the Y-Y' direction of the first portion 311 of the housing body 310 of the or a respective housing 300. The or each through-hole E1 allows the first portion 311 of the housing body 310 of the or a respective housing 300 to be inserted therethrough in the Z' direction. Accordingly, the portion or portions of the seal member E that surround the or each through-hole E1 is located around the first portion 311 of the housing body 310 of the or a respective housing 300.

Where the first fixing part 410 includes the at least one first protrusion 412, the seal member E may further include at least one through-hole E2 disposed corresponding in position to the at least one first protrusion 412. The at least one through-hole E2 extends through the seal member E in the Z-Z' direction. The or each through-hole E2 is shaped so as to have a cross-sectional dimension in the Y-Y' direction that is substantially the same as, or slightly larger than, the outer cross-sectional dimension in the Y-Y' direction of the or a respective first protrusion 412. The or each through-hole E2 allows the corresponding first protrusion 412 to be inserted therethrough in the Z' direction. Accordingly, the portion or portions of the seal member E that surround the or each through-hole E2 is located around the or a respective first protrusion 412. Where the at least one first protrusion 412 is omitted, it is preferable to omit the at least one through-hole E2. Where the at least one first protrusion 412 is arranged around, or outside, the seal member E, the at least one through-hole E2 may be omitted.

In the embodiment shown in Figs. 6A to 6D and 8, the first fixing part 410 includes three first protrusions 412, and the seal member E is provided with a single through-hole E2. The three first protrusions 412 consist of a central first protrusions 412, a first protrusion 412 on the Y-direction side relative to (i.e. outside) the seal member E, and a first protrusion 412 on the Y'-direction side relative to (i.e. outside) the seal member E. The through-hole E2 of the seal member E is associated with the central first protrusion 412, and no through-holes E2 are provided in association with the first protrusions 412 on the Y- and Y'-direction sides. Also in this embodiment, as shown in Figs. 6D and 7, the adherend 10 of the headliner H has three positioning holes 14 respectively associated with the three first protrusions 412.

The following describes first and second methods for mounting the at least one electronic component 100 to the adherend 10. Here, these first and second methods here each include a method for assembling the assembly D' and a method for mounting the assembly D' to the adherend 10. For convenience description, the first method will be described for the case where there are provided a single electronic component 100, a single holder 200, a single housing 300, a single opening 423 or cutout of the fixing part 400, and a single leg 520 of the support 500. However, it is also possible to assemble the assembly D' in a similar manner by the first method also in the case where there are provided a plurality of electronic components 100, a plurality of holders 200, a plurality of housings 300, a plurality of openings 423 or cutouts of the fixing part 400, and a plurality of legs 520 of the support 500. Also, the second method will be described for the case where there are provided a single electronic component 100, a single holder 200, a single housing 300, and a single opening 423 or cutout of the fixing part 400. However, it is also possible to assemble the assembly D' in a similar manner by the second method also in the case where there are provided a plurality of electronic components 100, a plurality of holders 200, a plurality of housings 300, and a plurality of openings 423 or cutouts of the fixing part 400.

First, the following description is directed to the method for assembling the assembly D' of the first method. The steps of the first for assembling the assembly D' of the first method are the same as those of the method for assembling the assembly D of the first method, except for the following steps.

Where the assembly D' is to include the seal member E fixed to the face of the first fixing part 410 on the Z'-direction side, the method for assembling the assembly D' includes bonding or otherwise fixing the seal member E to the face of the first fixing part 410 on the Z'-direction side before or after the electronic component 100 and the holder 200, or the electronic component 100, is held in the housing 300. When the seal member E is fixed, the or each first portion 311 of the housing body 310 of the or a respective housing 300 is inserted in the Z' direction through the or a respective through-hole E1 of the seal member E. Where the seal member E is also provided with the at least one through-hole E2, the first portion 311 of the housing body 310 of the or each housing 300 is inserted through the or a respective through-hole E1 of the seal member E, and the or each first protrusion 412 is inserted through the or a respective through-hole E2 of the seal member E.

Where the assembly D' is to include the seal member E to the mounting face 421a of the second fixing part 420, or to the face on the Z'-direction side of the first fixing part 410 and the mounting face 421a of the second fixing part 420, the method for assembling the assembly D' includes bonding or otherwise fixing the seal member E to the mounting face 421a of the second fixing part 420, or to the face on the Z'-direction side of the first fixing part 410 and the mounting face 421a of the second fixing part 420, after fixing the first fixing part 410 to the second fixing part 420 in a manner as described above. When the seal member E is fixed, the first portion 311 of the housing body 310 of the or each housing 300 is inserted in the Z' direction through the or a respective through-hole E1 of the seal member E. Where the seal member E is also provided with the at least one through-hole E2, the first portion 311 of the housing body 310 of the or each housing 300 is inserted through the or a respective through-hole E1 of the seal member E, and the or each first protrusion 412 is inserted through the or a respective through-hole E2 of the seal member E.

The following description is directed to the method for mounting the assembly D' to the adherend 10 of the first method. The steps of the first method for mounting the assembly D' to the adherend 10 are the same as those of the first method for mounting the assembly D to the adherend 10, except for the following steps.

The mounting face 421a of the second fixing part 420 of the assembly D' is mounted on the first face 11a of the adherend 10. At this time, the seal member E, which is on at least one of the face on the Z'-direction side of the first fixing part 410 and the mounting face 421a of the second fixing part 420 of the assembly D' ("at least one of the attachable faces" for short), is sandwiched between at least one of the attachable faces and the first face 11a of the adherend 10, and the first portion 311 of the or each housing body 310 of the assembly D' is inserted into the or a respective housing hole 13 of the adherend 10.

The seal member E thus mounted is then compressed between at least one of the attachable faces and the first face 11a of the adherend 10. In this state, the second fixing part 420 of the assembly D' is bonded, welded, or otherwise fixed to the first face 11a of the adherend 10 by bonding or welding.

The following description is directed to the method for assembling the assembly D' of the second method. This method is similar to, but different in respects below from, the method for assembling the assembly D' of the first method, and therefore, will be described focusing on the differences. This method deals with the assembly D' with the support 500 omitted.

When the or each electronic component 100 and the or a respective holder 200 are housed inside the housing body 310 of the or a respective housing 300, the or each holder 200 is fitted in, and held by, the or a respective housing body 310. In this way, the or each electronic component 100 and the or a respective holder 200 are held inside the or a respective housing 300 fixed to the or a respective first fixing part 410.

Where the at least one holder 200 is omitted, the or each electronic component 100 is housed in the housing body 310 of the or a respective housing 300, when the or each electronic component 100 is fitted in, and held by, the or a respective the housing body 310. In this way, the or each electronic component 100 is held inside the or a respective housing 300 fixed to first fixing part 410.

The method for mounting the assembly D' to the adherend 10 of the second method is similar to the method for mounting the assembly D' to the adherend 10 of the first method, and will not be described to avoid overlapping descriptions.

Where the assembly D' includes the circuit board 600, the circuit board 600 may be fixed to the first fixing part 410 in a manner described manner after the electronic component 100 and the holder 200, or alternatively the electronic component 100, is held inside the housing 300. The circuit board 600 may be electrically connected to the electronic component 100 via a connection means described above, either before or after the circuit board 600 is fixed to the first fixing part 410. The circuit board 600 may be prepared with or without the at least one circuit part 700 and/or the connector 800 mounted thereon. Where the circuit board 600 is omitted, the steps in this paragraph should be omitted.

The first and second methods may be such that the assembly D' is attached to the adherend 10 after the assembly D' is assembled as described above, but the first and/or second methods may be modified in the order of the steps as follows. The second fixing part 420 may be fixed to the first face 11a of the adherend 10 before the electronic component 100 and the holder 200, or alternatively the electronic component 100, is held inside the housing 300 fixed to the first fixing part 410. After that, the first fixing part 410 with the housing 300 may be fixed to the second fixing part 420, and then the electronic component 100 and the holder 200, or alternatively the electronic component 100, may be held inside the housing 300 fixed to the first fixing part 410. In this case, it is preferable that the seal member E be fixed to the mounting face 421a of the second fixing part 420 before the second fixing part 420 is fixed to the first face 11a of the adherend 10. It is also preferable that the seal member E be thereafter held and compressed between the mounting face 421a of the second fixing part 420 and the first face 11a of the adherend 10, and that in this state the second fixing part 420 be fixed to the first face 11a of the adherend 10.

The combination S', the assembly D', and the first and second methods described above provide at least the technical features and effects (a) to (e) described above and the technical feature and effect (f) described below.

(f) The seal member E is provided to surround the first portion 311 of the housing body 310 of the at least one housing 300, and the seal member E is compressed between the face on the Z'-direction side of the fixing part 400 of the assembly D' and the first face 11a of the adherend 10 of the headliner H. This arrangement prevents dust and dirt from entering a ceiling part of a vehicle through a gap between the face on the Z'-direction side of the fixing part 400 and the first face 11a of the adherend 10 of the headliner H. In addition, where the first portion 311 of the housing body 310 of the at least one housing 300 houses a microphone as the electronic component 100 (or one or each of the electronic components 100), the seal member E, which is compressed between the face on the Z'-direction side of the fixing part 400 of the assembly D' and the first face 11a of the adherend 10 of the headliner H, suppresses entry of sounds from the Z-direction side relative to the assembly D' into a sound hole of the microphone.

The combinations of electronic component assemblies and adherends, the electronic component assemblies, and the methods for mounting an electronic component described above are not limited to the above-described embodiments, and may be modified within the scope of claims in the following manners, for example.

The seal member of any of the above aspects may not be fixed to the face on the Z'-direction side of a fixing part of an electronic component assembly, but simply compressed and held between a fixing part of an electronic component assembly described above and the first face of an adherend described above. In this case, the seal member is not part of the electronic component assembly but part of the combination of the electronic component assembly and the adherend. Also in this case, the first and second methods may be such that the seal member be held between a fixing part of the electronic component assembly and the first face of the adherend when the fixing part is placed on the first face. The seal member of the invention may be omitted.

The first fixing part 410 and the second fixing part 420 of the fixing part 400 of any of the above may be separate parts as described above or may be provided as an integrated fixing part. The integrated first and second parts 410, 420 may have any aspect described above but be dispensed with the at least one engaging claw 422, the at least one second protrusion 413, the at least one positioning hole 424, and the at least one positioning portion 425. Also in this case, the first and second methods of any aspects above are modified to be dispensed with the step of fixing the first fixing part 410 to the second fixing part 420.

The fixing part of the invention may be fixed to the first face of the adherend by bonding or welding as described above, or by any other fixing method as long as the fixing part is fixed to the first face of the adherend without protruding in the Z' direction relative to the second face of the adherend. For example, one of the fixing part and the adherend of any of the above aspects may be provided with at least one engaging protrusion, and the other with at least one engaging hole, and the at least one engaging protrusion may be fitted in the at least one engaging hole. Where the at least one engaging protrusion is provided on the fixing part of any of the above aspects, the or each engaging protrusion may have a dimension in the Z-Z' direction that is equal to, or smaller than, that of the adherend in the Z-Z' direction, so that the at least one engaging protrusion does not protrude in the Z' direction relative to the second face of the adherend. Alternatively, the fixing part of any of the above aspects may be fixed to the adherend of any of the above aspects with at least one screw. Also in this case, it is preferable that the at least one screw not protrude in the Z' direction relative to the second face of the adherend.

The electronic component, or one or each of the electronic components, of the invention may be an acoustic component as described above, but may be an electronic component of other kind. For example, the electronic component, or one or each of the electronic components, may be a sensor, a camera unit, a light emitting device, an active component, a passive component, a circuit board, or the like. Some examples of the sensor are a motion sensor, an acceleration sensor, a temperature sensor, a humidity sensor, a temperature and humidity sensor, or the like. The light emitting device may be an LED or the like. The active component may be a semiconductor device, an electric motor, or the like. The passive component may be a resistor, a capacitor, a coil, a transformer, a relay, a piezoelectric element, an oscillator, or the like.

As used herein the term "generally tubular shape" means a generally tubular shape as a whole. The generally tubular shape may have a cross section of a circular or polygonal shape, or of a circular or polygonal shape that is partly cut out, or the like.

The adherend of the invention may form part of a lining of a ceiling part of a vehicle as described above, but may be a component of other kind that includes a first face, a second face opposite to the first face, and at least one opening (housing hole) that opens in at least the first face to house the first portion of the at least one housing body of any of the above aspects.

The first and second directions of the invention may correspond to the directions along the thickness of the adherend of the invention as described above. The first direction may alternatively be any other direction in which the first face of the adherend faces and the housing hole opens. The second direction of the invention may be any direction opposite to the first direction.

### Reference Signs List

S, S': combination of electronic component assembly and adherend
   H: headliner (lining)
      10: adherend
         11: recess
         11a: first face
         12: second face
         13: housing hole
         14: positioning hole
      20: cushioning material
      30: cloth
   D, D': electronic component assembly
      100: electronic component
      200: holder
      300: housing
         310: housing body
            311: first portion
               311a: bottom
               311b: through-hole
            312: second portion
         320: fixed portion
            321: flange
            322: piece member
      400: fixing part
         410: first fixing part
            411: hole
            412: first protrusion
            413: second protrusion
         420: second fixing part
            421: base
               421a: mounting face
            422: engaging claw
            423: opening
            424: positioning hole
            425: protrusion
      500: support
         510: support body
         520: leg
      600: circuit board
      700: circuit part
      800: connector
      900: cover
      E: seal member
         E1, E2: through-hole

## Claims

1. A combination (S, S') of an electronic component assembly and an adherend, the combination (S, S') comprising:
an adherend (10) including a first face (11a) on a first-direction (Z) side, a second face (12) on a second-direction (Z') side, and a housing hole (13) opening in the first face (11a), the second direction (Z') being opposite to the first direction (Z); and
an electronic component assembly (D, D') comprising:
a fixing part (400) fixed to the first face (11a) of the adherend (10);
an electronic component (100); and
a housing (300) including:
a fixed portion (320) fixed to the fixing part (400); and
a housing body (310) to house the electronic component (100), the housing body (310) including a first portion (311) disposed on the second-direction (Z') side relative to the fixing part (400), wherein
the first portion (311) of the housing body (310) has a dimension in the second direction (Z') that is equal to, or smaller than, a dimension in the second direction (Z') of the housing hole (13) of the adherend (10), and
the first portion (311) of the housing body (310) is housed in the housing hole (13) of the adherend (10) without protruding in the second direction (Z') relative to the second face (12) of the adherend (10),
the housing body (310) is of a generally tubular shape opening in the first direction (Z) and including a bottom (311a) on the second-direction (Z') side,
the bottom (311a) of the housing body (310) is in direct or indirect abutment with the electronic component (100), and
the fixed portion (320) extends from the housing body (310) and is located on the first-direction (Z) side relative to the first portion (311) of the housing body (310),
**characterized in that**
the electronic component assembly (D, D') further comprises a support (500), the support (500) including:
a support body (510) fixed to the fixing part (400); and
a leg (520) extending from the support body (510) in the second direction (Z'), being received inside the housing body (310) of the housing (300), and being in direct or indirect abutment with the electronic component (100).

2. The combination (S, S') according to claim 1, wherein the bottom (311a) of the housing body (310) is provided with at least one through-hole (311b) extending through the bottom (311a) in the second direction (Z').

3. The combination (S, S') according to claim 1 or 2, wherein the housing (300) is formed of a thin metal plate.

4. The combination (S, S') according to according to any one of the preceding claims, wherein the electronic component assembly (D, D') further comprises:
a circuit board (600) fixed to the support body (510); and
at least one of a connector (800) or a circuit part (700), being mounted on the circuit board (600) and electrically connected to the electronic component (100).

5. The combination (S, S') according to any one of the preceding claims, wherein
the fixing part (400) includes a first fixing part (410) and a second fixing part (420),
the first fixing part (410) is attached the second fixing part (420),
the second fixing part (420) is fixed to the first face (11a) of the adherend (10), and
the fixed portion (320) of the housing (300) is fixed to the first fixing part (410).

6. The combination (S, S') according to any one of the preceding claims, wherein
the electronic component assembly (D, D') further comprises a holder (200) constituted by an elastic body, and
the holder (200) holds the electronic component (100) and is housed inside the housing (300) together with the electronic component (100).

7. The combination (S') according to any one of the preceding claims, wherein
the electronic component assembly (D, D') further comprises a seal member (E),
the seal member (E) is fixed to a face on the second-direction (Z') side of the fixing part (400) and in contact with the first face (11a) of the adherend (10),
the seal member (E) includes a through-hole (E1) extending in the second direction (Z') through the seal member (E), and
the first portion (311) of the housing body (310) of the housing (300) is inserted through the through-hole (E1).

8. The combination (S') according to claim 7, wherein the seal member (E) is compressed between the first face (11a) of the adherend (10) and the fixing part (400).

9. The combination (S, S') according to any one of the preceding claims, wherein
one of the fixing part (400) and the first face (11a) of the adherend (10) is provided with a first protrusion (412), and the other is provided with a positioning hole (14), and
the first protrusion (412) is fitted in the positioning hole (14).

10. A method for assembling an electronic component (100) to an adherend (10), the method comprising:
preparing an adherend (10) including a first face (11a) on a first-direction (Z) side, a second face (12) on a second-direction (Z') side, and a housing hole (13) opening in the first face (11a), the second direction (Z') being opposite to the first direction (Z);
preparing a fixing part (400) and a housing (300), the housing (300) including:
a housing body (310) opening in the first direction (Z) and including a first portion (311), the first portion (311) being disposed on a second-direction (Z') side relative to the fixing part (400), and
a fixed portion (320) fixed to the fixing part (400);
arranging the first portion (311) of the housing body (310) of the housing (300) to be housed in the housing hole (13) of the adherend (10), without protruding the first portion (311) of the housing body (310) to the second-direction (Z') side relative to the second face (12) of the adherend (10), and placing the fixing part (400) on the first face (11a) of the adherend (10);
fixing the fixing part (400) to the first face (11a) of the adherend (10);
preparing an electronic component (100) before or after placing the fixing part (400); and
arranging the prepared electronic component (100) to be housed inside the housing body (310)
**characterized in that**
the arranging of the electronic component (100) to be housed inside the housing body (310) includes bringing the electronic component (100) into abutment with a bottom (311a) of the housing body (310),
the method further comprises:
preparing a support (500), the support including a support body (510) and a leg (520) extending in the second direction (Z') from the support body (510);
after the electronic component (100) is housed inside the housing body (310), inserting the leg (520) of the support (500) into the housing body (310) of the housing (300) to bring the leg (520) into direct or indirect abutment with the electronic component (100); and
fixing the support body (510) to the fixing part (400).

11. The method according to claim 10, wherein
the electronic component (100) is held in a holder (200) constituted by an elastic body, and
the arranging of the electronic component (100) to be housed inside the housing body (310) includes arranging the electronic component (100) and the holder (200) to be housed inside the housing body (310) with the holder (200) in abutment with a bottom (311a) of the housing body (310),
the method further comprises:
preparing a support (500), the support including a support body (510) and a leg (520) extending in the second direction (Z') from the support body (510);
after the electronic component (100) and the holder (200) are housed inside the housing body (310), inserting the leg (520) of the support (500) into the housing body (310) of the housing (300) to bring the leg (520) into abutment with the holder (200); and
fixing the support body (510) to the fixing part (400).

## Patentansprüche

1. Kombination (S, S') aus einer Elektronikkomponentenanordnung und einem Halteelement, wobei die Kombination (S, S') Folgendes umfasst:
ein Halteelement (10) mit einer ersten Oberfläche (11a) auf einer in eine erste Richtung (Z) weisenden Seite, einer zweiten Oberfläche (12) auf einer in eine zweite Richtung (Z') weisenden Seite und einem in der ersten Oberfläche (11a) offenes Aufnahmeloch (13), wobei die zweite Richtung (Z') der ersten Richtung (Z) entgegengesetzt ist; und
eine Elektronikkomponentenanordnung (D, D'), die Folgendes umfasst:
ein Befestigungsteil (400), das an der ersten Oberfläche (11a) des Halteelements (10) befestigt ist;
eine Elektronikkomponente (100); und
eine Aufnahme (300), die Folgendes umfasst:
einen feststehenden Abschnitt (320), der an dem Befestigungsteil (400) befestigt ist; und
einen Aufnahmekörper (310) zum Aufnehmen der Elektronikkomponente (100), wobei der Aufnahmekörper (310) einen ersten Abschnitt (311) umfasst, der auf der in die zweite Richtung (Z') weisenden Seite relativ zu dem Befestigungsteil (400) angeordnet ist, wobei
der erste Abschnitt (311) des Aufnahmekörpers (310) eine Abmessung in der zweiten Richtung (Z') aufweist, die gleich oder kleiner als eine Abmessung in der zweiten Richtung (Z') des Aufnahmelochs (13) des Halteelements (10) ist, und
der erste Abschnitt (311) des Aufnahmekörpers (310) in dem Aufnahmeloch (13) des Halteelements (10) aufgenommen ist, ohne in der zweiten Richtung (Z') relativ zu der zweiten Oberfläche (12) des Halteelements (10) vorzustehen,
der Aufnahmekörper (310) eine allgemein röhrenförmige Form aufweist, die in der ersten Richtung (Z) offen ist und einen Boden (311a) auf der in die zweite Richtung (Z') weisenden Seite umfasst,
der Boden (311a) des Aufnahmekörpers (310) direkt oder indirekt an der Elektronikkomponente (100) anliegt, und
sich der feststehende Abschnitt (320) von dem Aufnahmekörper (310) erstreckt und sich auf der in die erste Richtung weisenden Seite (Z) relativ zu dem ersten Abschnitt (311) des Aufnahmekörpers (310) befindet,
**dadurch gekennzeichnet, dass**
die Elektronikkomponentenanordnung (D, D') ferner eine Halterung (500) umfasst, wobei die Halterung (500) Folgendes umfasst:
einen Halterungskörper (510), der an dem Befestigungsteil (400) befestigt ist; und
einen Schenkel (520), der sich von dem Halterungskörper (510) in der zweiten Richtung (Z') erstreckt, in dem Aufnahmekörper (310) der Aufnahme (300) aufgenommen ist und direkt oder indirekt an der Elektronikkomponente (100) anliegt.

2. Kombination (S, S') nach Anspruch 1, wobei der Boden (311a) des Aufnahmekörpers (310) mit mindestens einem Durchgangsloch (311b) versehen ist, das sich durch den Boden (311a) in der zweiten Richtung (Z') erstreckt.

3. Kombination (S, S') nach Anspruch 1 oder 2, wobei die Aufnahme (300) aus einem dünnen Metallblech gebildet ist.

4. Kombination (S, S') nach einem der vorangehenden Ansprüche, wobei die Elektronikkomponentenanordnung (D, D') ferner Folgendes umfasst:
eine Leiterplatte (600), die an dem Halterungskörper (510) befestigt ist; und
mindestens eines von einem Verbinder (800) und/oder einem Schaltungsteil (700), der bzw. das auf der Leiterplatte (600) angebracht ist und mit der Elektronikkomponente (100) elektrisch verbunden ist.

5. Kombination (S, S') nach einem der vorangehenden Ansprüche , wobei
das Befestigungsteil (400) ein erstes Befestigungsteil (410) und ein zweites Befestigungsteil (420) umfasst,
das erste Befestigungsteil (410) an dem zweiten Befestigungsteil (420) angebracht ist,
das zweite Befestigungsteil (420) an der ersten Oberfläche (11a) des Halteelements (10) befestigt ist, und
der feststehende Abschnitt (320) der Aufnahme (300) an dem ersten Befestigungsteil (410) befestigt ist.

6. Kombination (S, S') nach einem der vorangehenden Ansprüche , wobei
die Elektronikkomponentenanordnung (D, D') ferner eine Fassung (200) umfasst, die von einem elastischen Körper gebildet wird, und
die Fassung (200) die Elektronikkomponente (100) hält und zusammen mit der Elektronikkomponente (100) in der Aufnahme (300) aufgenommen ist.

7. Kombination (S') nach einem der vorangehenden Ansprüche, wobei:
die Elektronikkomponentenanordnung (D, D') ferner ein Dichtungselement (E) umfasst,
das Dichtungselement (E) an einer Oberfläche auf der in die zweite Richtung (Z') weisenden Seite des Befestigungsteils (400) befestigt ist und sich mit der ersten Oberfläche (11a) des Halteelements (10) in Kontakt befindet,
das Dichtungselement (E) ein Durchgangsloch (E1) umfasst, das sich in der zweiten Richtung (Z') durch das Dichtungselement (E) erstreckt, und
der erste Abschnitt (311) des Aufnahmekörpers (310) der Aufnahme (300) durch das Durchgangsloch (E1) gesteckt ist.

8. Kombination (S') nach Anspruch 7, wobei das Dichtungselement (E) zwischen der ersten Oberfläche (11a) des Halteelements (10) und dem Befestigungsteil (400) zusammengedrückt wird.

9. Kombination (S, S') nach einem der vorangehenden Ansprüche , wobei
eines von dem Befestigungsteil (400) und der ersten Oberfläche (11a) des Halteelements (10) mit einem ersten Vorsprung (412) versehen ist und das andere mit einem Positionierungsloch (14) versehen ist, und
der erste Vorsprung (412) in das Positionierungsloch (14) eingesetzt ist.

10. Verfahren zum Montieren einer Elektronikkomponente (100) an einem Halteelement (10), wobei das Verfahren Folgendes umfasst:
Bereitstellen eines Halteelements (10) mit einer ersten Oberfläche (11a) auf einer in eine erste Richtung (Z) weisenden Seite, einer zweiten Oberfläche (12) auf einer in eine zweite Richtung (Z') weisenden Seite und einem in der ersten Oberfläche (11a) offenen Aufnahmeloch (13), wobei die zweite Richtung (Z') der ersten Richtung (Z) entgegengesetzt ist;
Bereitstellen eines Befestigungsteils (400) und einer Aufnahme (300), wobei die Aufnahme (300) Folgendes umfasst:
einen Aufnahmekörper (310), der in der ersten Richtung (Z) offen ist und einen ersten Abschnitt (311) umfasst, wobei der erste Abschnitt (311) auf einer in die zweite Richtung (Z') weisenden Seite relativ zu dem Befestigungsteil (400) angeordnet ist, und
einen feststehenden Abschnitt (320), der an dem Befestigungsteil (400) befestigt ist;
Anordnen des ersten Abschnitts (311) des Aufnahmekörpers (310) der Aufnahme (300), um in dem Aufnahmeloch (13) des Halteelements (10) aufgenommen zu werden, ohne dass der erste Abschnitt (311) des Aufnahmekörpers (310) zu der in die zweite Richtung (Z') weisende Seite relativ zu der zweiten Oberfläche (12) des Halteelements (10) vorsteht, und Platzieren des Befestigungsteils (400) auf der ersten Oberfläche (11a) des Halteelements (10);
Befestigen des Befestigungsteils (400) an der ersten Oberfläche (11a) des Halteelements (10);
Bereitstellen einer Elektronikkomponente (100) vor oder nach dem Platzieren des Befestigungsteils (400); und
Anordnen der bereitgestellten Elektronikkomponente (100), um in dem Aufnahmekörper (310) aufgenommen zu werden,
**dadurch gekennzeichnet, dass**
das Anordnen der Elektronikkomponente (100), um in dem Aufnahmekörper (310) aufgenommen zu werden, das Bringen der Elektronikkomponente (100) zur Anlage an einem Boden (311a) des Aufnahmekörpers (310) umfasst,
wobei das Verfahren ferner Folgendes umfasst:
Bereitstellen einer Halterung (500), wobei die Halterung einen Halterungskörper (510) und einen Schenkel (520), der sich in der zweiten Richtung (Z') von dem Halterungskörper (510) erstreckt, umfasst;
nachdem die Elektronikkomponente (100) in dem Aufnahmekörper (310) aufgenommen ist, Einstecken des Schenkels (520) der Halterung (500) in den Aufnahmekörper (310) der Aufnahme (300), um den Schenkel (520) zur direkten oder indirekten Anlage an der Elektronikkomponente (100) zu bringen; und
Befestigen des Halterungskörpers (510) an dem Befestigungsteil (400).

11. Verfahren nach Anspruch 10, wobei:
die Elektronikkomponente (100) in einer Fassung (200) gehalten wird, der von einem elastischen Körper gebildet wird, und
das Anordnen der Elektronikkomponente (100), um in dem Aufnahmekörper (310) aufgenommen zu werden, das Anordnen der Elektronikkomponente (100) und der Fassung (200), um in dem Aufnahmekörper (310) aufgenommen zu werden, derart umfasst, dass die Fassung (200) an einem Boden (311a) des Aufnahmekörpers (310) anliegt,
wobei das Verfahren ferner Folgendes umfasst:
Bereitstellen einer Halterung (500), wobei die Halterung einen Halterungskörper (510) und einen Schenkel (520), der sich in der zweiten Richtung (Z') von dem Halterungskörper (510) erstreckt, umfasst;
nachdem die Elektronikkomponente (100) und die Fassung (200) in dem Aufnahmekörper (310) aufgenommen sind, Einstecken des Schenkels (520) der Halterung (500) in den Aufnahmekörper (310) der Aufnahme (300), um den Schenkel (520) zur Anlage an der Fassung (200) zu bringen; und
Befestigen des Halterungskörpers (510) an dem Befestigungsteil (400).

## Revendications

1. Combinaison (S, S') d'un ensemble de composants électroniques et d'une surface à coller, la combinaison (S, S') comprenant :
une surface à coller (10) comprenant une première face (11a) sur un côté de première direction (Z), une seconde face (12) sur un côté de seconde direction (Z') et un trou de logement (13) s'ouvrant dans la première face (11a), la seconde direction (Z') étant opposée à la première direction (Z) ; et
un ensemble de composants électroniques (D, D') comprenant :
une pièce de fixation (400) fixée à la première face (11a) de la surface à coller (10)
un composant électronique (100) ; et
un logement (300) comprenant :
une partie fixe (320) fixée à la pièce de fixation (400) ; et
un corps de logement (310) destiné à loger le composant électronique (100), le corps de logement (310) comprenant une première partie (311) disposée sur le côté de seconde direction (Z') par rapport à la pièce de fixation (400), dans lequel
la première partie (311) du corps de logement (310) a une dimension dans la seconde direction (Z') qui est égale ou inférieure à une dimension dans la seconde direction (Z') du trou de logement (13) de la surface à coller (10), et
la première partie (311) du corps de logement (310) est logée dans le trou de logement (13) de la surface à coller (10) sans dépasser dans la seconde direction (Z') par rapport à la seconde face (12) de la surface à coller (10),
le corps de logement (310) est de forme généralement tubulaire s'ouvrant dans la première direction (Z) et comprenant un fond (311a) sur le côté de seconde direction (Z'),
le fond (311a) du corps de logement (310) est en aboutement direct ou indirect avec le composant électronique (100), et
la partie fixe (320) s'étend à partir du corps de logement (310) et est située sur le côté de première direction (Z) par rapport à la première partie (311) du corps de logement (310),
**caractérisé en ce que**
l'ensemble de composants électroniques (D, D') comprend en outre un support (500), le support (500) comprenant :
un corps de support (510) fixé à la pièce de fixation (400) ; et
une jambe (520) s'étendant à partir du corps de support (510) dans la seconde direction (Z'), reçue à l'intérieur du corps de logement (310) du logement (300) et étant en aboutement direct ou indirect avec le composant électronique (100).

2. Combinaison (S, S') selon la revendication 1, dans laquelle le fond (311a) du corps de logement (310) est pourvu d'au moins un trou traversant (311b) qui s'étend à travers le fond (311a) dans la seconde direction (Z').

3. Combinaison (S, S') selon la revendication 1 ou 2, dans laquelle le logement (300) est formé d'une fine plaque métallique.

4. Combinaison (S, S') selon l'une quelconque des revendications précédentes, dans laquelle l'ensemble de composants électroniques (D, D') comprend en outre :
une carte de circuit imprimé (600) fixée au corps de support (510) ; et
au moins un connecteur (800) ou une partie de circuit (700), monté sur la carte de circuit imprimé (600) et connecté électriquement au composant électronique (100).

5. Combinaison (S, S') selon l'une quelconque des revendications précédentes, dans laquelle
la pièce de fixation (400) comporte une première pièce de fixation (410) et une seconde pièce de fixation (420),
la première pièce de fixation (410) est fixée à la seconde pièce de fixation (420),
la seconde pièce de fixation (420) est fixée à la première face (11a) de la surface à coller (10), et
la partie fixe (320) du logement (300) est fixée à la première pièce de fixation (410).

6. Combinaison (S, S') selon l'une quelconque des revendications précédentes, dans laquelle
l'ensemble de composants électroniques (D, D') comprend en outre un support (200) constitué d'un corps élastique, et
le support (200) contient le composant électronique (100) et est logé à l'intérieur du logement (300) avec le composant électronique (100).

7. Combinaison (S') selon l'une quelconque des revendications précédentes, dans laquelle
l'ensemble de composants électroniques (D, D') comprend en outre un élément d'étanchéité (E),
l'élément d'étanchéité (E) est fixé à une face sur le côté de seconde direction (Z') de la pièce de fixation (400) et en contact avec la première face (11a) de la surface à coller (10),
l'élément d'étanchéité (E) comprend un trou traversant (E1) qui s'étend dans la seconde direction (Z') à travers l'élément d'étanchéité (E), et
la première partie (311) du corps de logement (310) du logement (300) est insérée à travers le trou traversant (E1).

8. Combinaison (S') selon la revendication 7, dans laquelle l'élément d'étanchéité (E) est comprimé entre la première face (11a) de la surface à coller (10) et la partie de fixation (400).

9. Combinaison (S, S') selon l'une quelconque des revendications précédentes, dans laquelle
l'une de la pièce de fixation (400) et de la première face (11a) de la surface à coller (10) est pourvue d'une première protubérance (412), et l'autre est pourvue d'un trou de positionnement (14), et
la première protubérance (412) est ajustée dans le trou de positionnement (14).

10. Procédé d'assemblage d'un composant électronique (100) sur une surface à coller (10), le procédé comprenant :
la préparation d'une surface à coller (10) comportant une première face (11a) sur un côté de première direction (Z), une seconde face (12) sur un côté de seconde direction (Z') et un trou de logement (13) s'ouvrant dans la première face (11a), la seconde direction (Z') étant opposée à la première direction (Z) ;
la préparation d'une pièce de fixation (400) et d'un logement (300), le logement (300) comportant :
un corps de logement (310) s'ouvrant dans la première direction (Z) et comportant une première partie (311), la première partie (311) étant disposée sur un côté de seconde direction (Z') par rapport à la pièce de fixation (400), et
une partie fixe (320) fixée à la pièce de fixation (400) ;
la disposition de la première partie (311) du corps de logement (310) du logement (300) à loger dans le trou de logement (13) de la surface à coller (10), sans faire dépasser la première partie (311) du corps de logement (310) vers le côté de seconde direction (Z') par rapport à la seconde face (12) de la surface à coller (10), et le placement de la pièce de fixation (400) sur la première face (11a) de la surface à coller (10) ;
la fixation de la pièce de fixation (400) à la première face (11a) de la surface à coller (10)
la préparation d'un composant électronique (100) avant ou après le placement de la pièce de fixation (400) ; et
l'agencement du composant électronique préparé (100) à loger à l'intérieur du corps de logement (310)
**caractérisé en ce que**
l'agencement du composant électronique (100) à loger à l'intérieur du corps de logement (310) comprend l'amenée du composant électronique (100) en aboutement avec un fond (311a) du corps de logement (310),
le procédé comprenant en outre :
la préparation d'un support (500), le support comportant un corps de support (510) et une jambe (520) s'étendant dans la seconde direction (Z') à partir du corps de support (510) ;
après le logement du composant électronique (100) à l'intérieur du corps de logement (310), l'insertion de la jambe (520) du support (500) dans le corps de logement (310) du logement (300) pour amener la jambe (520) en un aboutement direct ou indirect avec le composant électronique (100) ; et
la fixation du corps de support (510) à la pièce de fixation (400).

11. Procédé selon la revendication 10, dans lequel
le composant électronique (100) est maintenu dans un support (200) constitué d'un corps élastique, et
l'agencement du composant électronique (100) à loger à l'intérieur du corps de logement (310) comporte l'agencement du composant électronique (100) et du support (200) à loger à l'intérieur du corps de logement (310) avec le support (200) en aboutement avec un fond (311a) du corps de logement (310),
le procédé comprenant en outre :
la préparation d'un support (500), le support comportant un corps de support (510) et une jambe (520) qui s'étend dans la seconde direction (Z') à partir du corps de support (510) ;
après que le composant électronique (100) et le support (200) sont logés à l'intérieur du corps de logement (310), l'insertion de la jambe (520) du support (500) dans le corps de logement (310) du logement (300) pour amener la jambe (520) en aboutement avec le support (200) ; et la fixation du corps de support (510) à la partie de fixation (400).
